Europäisches Patentamt

(19) European Patent Office

Office européen des brevets

(11) Publication number: **0 163 077**
**B1**

(12) **EUROPEAN PATENT SPECIFICATION**

(45) Date of publication of patent specification: **23.11.89**    (51) Int. Cl.⁴: **H 01 L 23/48**

(21) Application number: **85104319.0**

(22) Date of filing: **10.04.85**

(54) Method of making packaged IC chip.

<table>
<tr><td>

(30) Priority: **02.05.84 US 606311**

(43) Date of publication of application:
**04.12.85 Bulletin 85/49**

(45) Publication of the grant of the patent:
**23.11.89 Bulletin 89/47**

(84) Designated Contracting States:
**AT BE DE FR GB IT NL**

(56) References cited:
**EP-A-0 023 165**
**US-A-4 137 546**
**US-A-4 289 922**

</td><td>

(73) Proprietor: **GTE Products Corporation**
**100 West 10th Street**
**Wilmington, DE 19801 (US)**

(72) Inventor: **Gilder, Thomas G., Jr.**
**1169 Fairview Drive**
**York, PA 17403 (US)**
Inventor: **O'Dean, Raymond D.**
**3620 Willow Road**
**Dover, PA 17315 (US)**

(74) Representative: **Patentanwälte Grünecker,**
**Kinkeldey, Stockmair & Partner**
**Maximilianstrasse 58**
**D-8000 München 22 (DE)**

</td></tr>
</table>

Courier Press, Leamington Spa, England.

## Description

This invention concerns lead frames for use with integrated circuit chips. The manufacture of such lead frames is disclosed in, for example, the following U.S. patents: 4,204,317; 4,137,546; 3,750,277; 3,537,175; 3,469,953. After an IC chip has been mounted on a lead frame chip carrier, and electrically connected to the leads thereof, it is often packaged in encapsulating material. Such packaged chip-containing lead frames are shown in, for example, the following U.S. patents: 4,331,831; 4,301,464; 4,298,883; 4,264,917; 4,214,364; 4,132,856; 4,124,864; 4,079,511; 3,978,516; 3,793,474; 3,684,464; 3,659,821; 3,611,061; 3,436,810.

As pointed out in the above patents, the lead frames are usually made by stamping or etching metal strips. Where the manufactured quantities are sufficiently great, stamping is preferred because of its lower cost.

As the circuits on the chips become more complex, a greater number of leads per lead frame is required. This complicates the stamping operation. Stamping is carried out in progressive dies; that is, a metal strip is fed through a stamping press having successive punch and die sets at a number of stations, where successive stamping operations are carried out. For examnple, a lead frame having 68 leads would require about 15 to 20 stamping stations and about 140 to 150 cuts. As the number of required stamping stations and cuts increases, the difficulty in maintaining adequate quality of the stamped lead frames also increases.

This invention can reduce the number of required stamping stations and cuts per lead frame. This is accomplished by not making an entire lead frame out of one integral metal strip, as was done in the prior art. Instead, the lead frame is fabricated from a plurality of individual segments which can be fabricated from the same set of stamping tools. Thus, if two segments are used per lead frame, the number of stamping stations can be about halved and the number of cuts can be reduced even more. And if four segments are used per lead frame, the number of stamping stations and cuts can be reduced an even greater extent. The lead frame is manufactured by assembling the segments with precise positioning, and then securing the segments in a suitable support to maintain said precise positions. An IC chip can then be disposed thereon and electrically connected to the leads.

This invention is particularly concerned with the manufacture of a packaged IC chip where the leads of each lead frame segment are connected at their ends to opposing rails until the leads are co-planarly secured to the support, after which the rails are removed.

Reference is made to a copending European patent application no. 85104411.5 wherein an IC chip is tested before it is encapsulated.

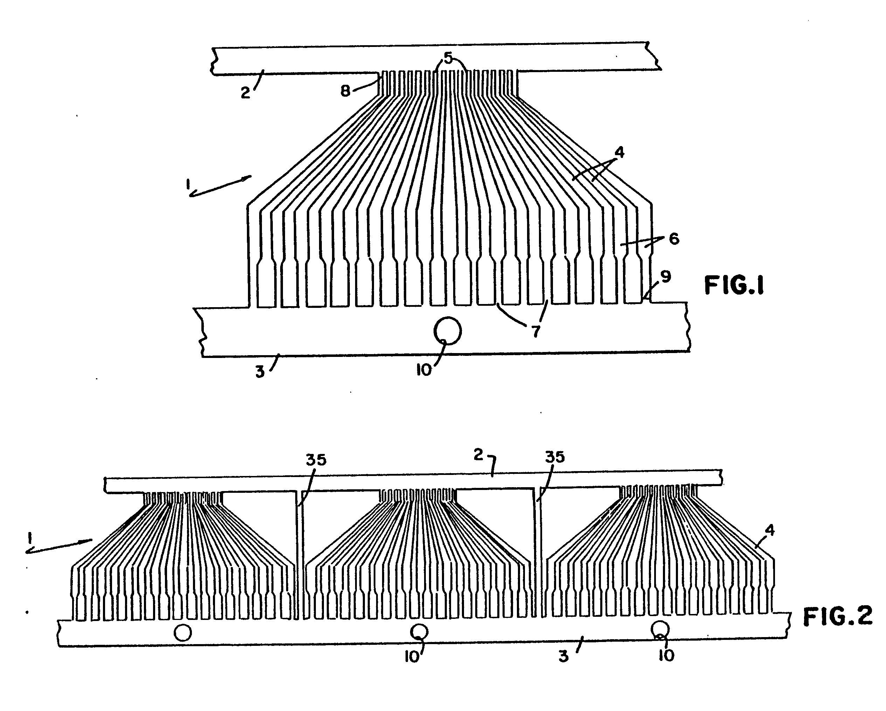

In the drawing, Fig. 1 shows a lead frame segment after stamping and Fig. 2 shows a strip of such lead frame segments.

Fig. 3 is a plan end view of a support for a lead frame.

Fig. 4 shows the support with three lead frame segments attached and the fourth ready for attachment.

Fig. 5 shows the support with all lead frame segments attached and the leads formed.

Figs. 6 and 7 are plan and end views of a cover for the support.

Fig. 8 shows the finished chip-containing lead frame package.

In one embodiment, substantially identical lead frame segments 1 were stamped from a long metal strip, as shown in Fig. 2. One such segment 1 is shown in Fig. 1. In one example, segments 1 were stamped from 0.254 mm (10 mil) copper alloy, specifically, Olin CDA194, and were maintained in strip form by means of continuous rails 2 and 3, as shown in Fig. 2. Between segments 1 there were support bars 35 extending from rail 3 to rail 2. Each segment 1 comprised seventeen leads 4. The inner ends 5 of leads 4, which would eventually be electrically connected to an IC chip, were 0.2286 mm (9 mils) wide and spaced 0.2286 mm (9 mils) apart. The widest parts 6 of leads 4 were inward from the outer ends 7 thereof and were 0.7112 mm (28 mils) wide spaced 0.5588 mm (22 mils) apart. Outer ends 7 were 0.4572 mm (18 mils) wide spaced 0.8128 mm (32 mols) apart. There were score lines 8 and 9 on leads 4 about 0.127 mm (5 mils) from rails 2 and 3. Rails 2 and 3 would eventually be broken off at score lines 8 and 9. There were 1.5748 mm (62 mil), diameter holes 10 in rail 3, which provided means for precise positioning of the lead frame segments during indexing of the copper strip during processing. Rails 2 and 3 were 1.6002 mm (63 mils) and 2.54 mm (100 mils) wide, respectively. The distance between score lines 8 and 9 was 12.192 mm (480 mils).

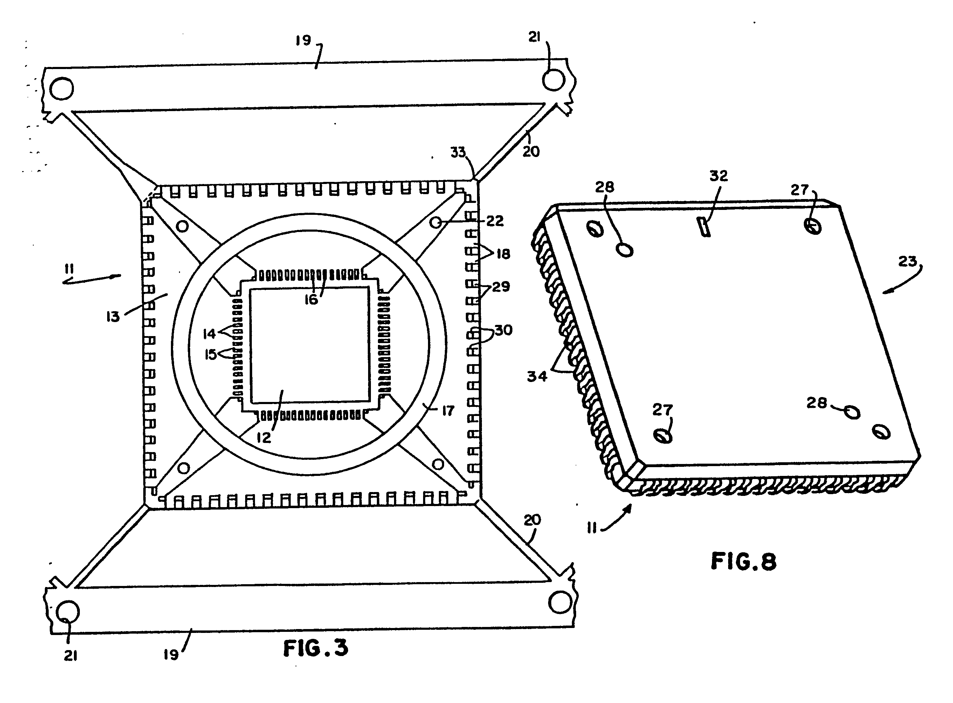

Support 11 for this example, shown in Fig. 3, was made of a high temperature thermoplastic material, specifically a polyetherimide resin made by General Electric Co., Pittsfield, Mass., under the trade name Ultem. In the center of support 11 was a recess 12 in which an IC chip would eventually be disposed. Recess 12 was 8.636 mm (340 mils) square and was recessed 0.2032 mm (8 mils) below surface 13 of support 11. Surrounding recess 12 were seventy-two raised projections 14, eighteen per side. Projections 14 were 0.1778 mm (7 mils) wide by 0.635 mm (25 mils) long by 0.2286 mm (9 mils) high. Spaces 15 between the projections were 3.0734 mm (11 mils) wide. At assembly of segments 1 to support 11, narrow ends 5 of leads 4 would lie on surface 13 in spaces 15 between projections 14. This provides means for accurate co-planar positioning of ends 5 in support 11. On the inner end of each projection 14 was another raised portion 16, measuring 0.1778 mm (7 mils) wide by 0.254 mm (10 mils) long by 0.1524 mm (6 mils) high. Raised portions 16 provided means for securing the leads in spaces 15 by, for example heating and slightly flowing plastic portion 16 over the leads. There was an encircling trough 17 outside the perimeter formed by all the projections 14.

At the periphery of support 11 there were sixty-eight slots 18 in which parts 6 of leads 4 would fit. Slots 18 were formed by projections 29 which were similar to projections 14 but bigger. Projections 29 were 0.508 mm (20 mils) wide by 0.8182 mm (32 mils) long by 0.2286 mm (9 mils) high. Slots 18 were 0.762 mm (30 mils) wide. Three were raised portions 30 on the inner ends of projections 29, similar to raised portions 16 on projections 14. Raised portions 30 were 0.508 mm (20 mils) wide by 0.254 mm (10 mils) long by 0.1524 mm (6 mils) high.

In order to permit supports 11 to be processed in existing manufacturing equipment for chip-carrying lead frames, there were rails 19, compatible with said equipment, spaced from each side of support 11 and connected thereto by tie bars 20. Rails 19 were 0.254 mm (10 mils) thick by 3.429 mm (135 mils) wide and were 35.56 mm (1.400 inches) apart from each other. Holes 21 provided means for accurate positioning of the supports during indexing. There were four posts 22 on support 11 for accurate mating of support 11 with cover 23, which was made of the same plastic as support 11.

Cover 23 had a recess 24 to mate with recess 12, and had an additional recess 25 to accommodate projections 14. Cover 23 also had a trough 26 to mate with trough 17, and four holes 27 into which posts 22 fit. There were also two holes 28 connecting with trough 26. After assembly of cover 23 onto support 11, a sealant material could be injected into holes 28 to fill troughs 17 and 26 in order to seal the IC chip from the environment.

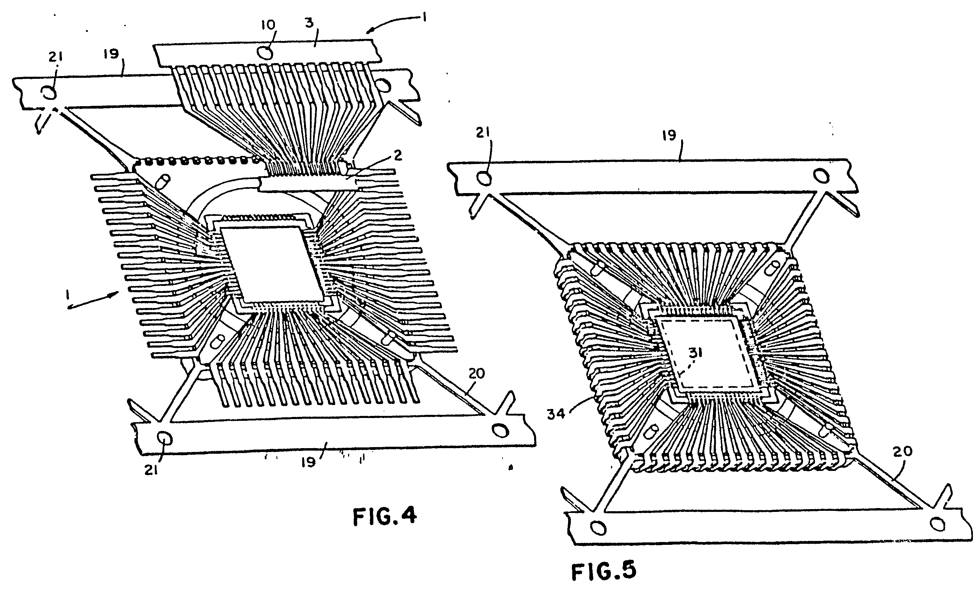

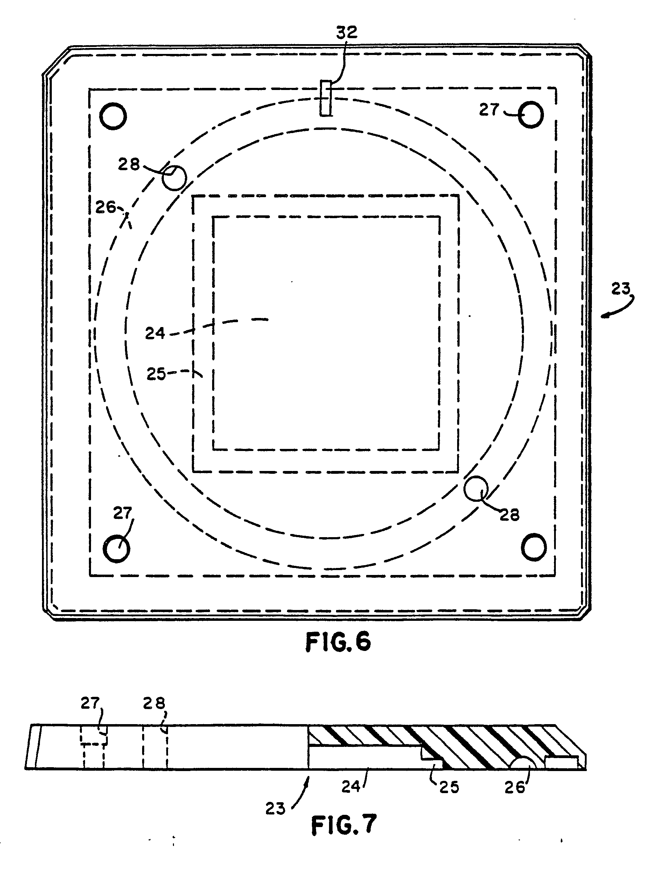

Assembly of the components would proceed as follows. Four lead frame segments 1, with rails 2 and 3 still attached, would be placed on top of support 11, one at a time and one in each quadrant, as shown in Fig. 5. Each segment 1, with rails 2 and 3 still attached thereto but with rail 2 having between trimmed sufficiently to fit the space, as shown in Fig. 4, would be carefully positioned so that ends 5 lay in spaces 15 and parts 6 lay in slots 18. Pressure would then be applied to segment 1 to ensure that it was flush against surface 13 and then, maintaining the pressure, heat would be applied to portions 16 and 30 to cause them to flow over, and secure in place, ends 5 and parts 6 of leads 4. Rails 2 and 3 would then be broken off at score lines 8 and 9. This process would be repeated for each lead frame segment 1. This construction ensures accurate positioning, with secure attachment, of all sixty-eight leads with excellent co-planarity thereof.

Next, an IC chip 31, shown in dotted lines in Fig. 5, would be conventionally attached in the pad area, recess 12, and would be conventionally electrically connected to ends 5 of leads 4. The rail construction of support 11 permits this processing to be performed on existing chip-carrier lead frame processing equipment. An advantage of this invention is that the IC chip and package can now be tested for electrical characteristics, because all sixty-eight leads are now electrically isolated, and repair of electrical connections can be made, if necessary. In the past, such repair could not be made because the leads were not electrically isolated until after packaging. The external ends of leads 4 can now be formed into a desired shape, such as "J" lead shape 34 shown in Figs. 5 and 8.

Next cover 23 is placed on support 11, posts 22 fitting into holes 27. Holes 27 are counterboard about half-way through as shown in Fig. 7, for example, to 1.0922 mm (43 mils) diameter from 0.8382 mm (33 mils) diameter. Posts 27 extend somewhat in the counterbores of holes 27, thereby providing the means for securing cover 23 to support 11 by heat-flowing the extending upper ends of posts 27, as raised portions 16 and 30 were heat-flowed. Next, a sealant, for example, a silicone gel, is pumped into holes 28 to completely fill troughs 17 and 26 as well as holes 28. The sealant should be sufficiently adherent and flexible, after curing, to maintain a hermetic seal through normal thermal cycling requirements. If desired, assembly of cover 23 and sealing of trough 17 and 28 can be performed in an atmosphere having greater heat dissipation characteristics than air such as helium. This atmosphere will be sealed in the recesses in which chip 31 is disposed. To complete the package, a lead identifier 32 may be used, as shown in Fig. 8, and rails 19 and tie bars 20 are removed at score lines 33.

The finished unit, shown in Fig. 8, had overall measurements, including formed leads 34, of 25.0952 mm (988 mils) square by 4.445 mm (175 mils) high.

This invention is also applicable to lead frames made other than by stamping, such as etching or chemical forming. Therefore, a significant advantage to the use of segments as per this invention is a substantial reduction in tooling cost.

## Claims

1. A method of making a packaged IC chip characterized by the steps of:

preparing a plurality of lead frame segments (1) each having a plurality of leads (4) and each of the leads (4) being connected at its ends to opposing rails (2, 3), securing the lead frame segments (1) to an insulating lead frame support (11), the individual leads (4) thereof being individually secured to the support (11); removing the rails (2, 3) the segments (1) being secured in sequence, the rails (2, 3) on each segment (1) being removed after securement thereof but prior to securement of the next segment (1), disposing an IC chip on the support (11) and making electrical connections between the chip and the leads (4); and disposing a cover (23) on the support (11), the chip and lead frame segments (1) being encapsulated between the support (11) and cover (23).

2. The method of claim 1 characterized in that the lead frame segments (1) are prepared from a longitudinal strip containing a plurality of segments (1), the segments (1) and leads (4) thereof being connected to opposing continuous rails (2, 3), the space between leads (4) being wider at one of the rails (3) than at the other rail (2).

3. The method of claim 1 or 2 characterized in that the leads (84) are secured between raised projections (14, 29) on the support (11).

**Patentansprüche**

1. Verfahren zur Herstellung eines gepackten IC-Chips gekennzeichnet durch die Verfahrensschritte:

Herstellen einer Vielzahl von Leiterrahmensegmenten (1), wobei jedes Segment eine Vielzahl von Leiter (4) und jeder von diesen Leitern (4) an seinen Enden mit einander gegenüberliegenden Riegeln (2, 3) verbunden ist;

Befestigen der Leiterrahmensegmente (1) auf einem isolierenden Leiterrahmenträger (11), wobei die einzelnen Leiter (4) auf dem Träger (11) einzeln befestigt werden;

Entfernen der Riegel (2, 3), wobei die Segmente (1) nacheinander befestigt werden, die Riegel (2, 3) von jedem Segment (1) nach dessen Befestigung aber vor der Befestigung des nächsten Segments (1) entfernt werden;

Anordnen eines IC-Chips auf dem Träger (11) und Herstellen elektrischer Verbindungen zwischen dem Chip und den Leitern (4); und

Anordnen einer Abdeckung (23) auf dem Träger (11), wobei der Chip und die Leiterrahmensegmente (1) zwischen dem Träger (11) und der Abdeckung (23) eingeschlossen werden.

2. Verfahren nach Anspruch 1, dadurch gekennzeichnet, daß die Leiterrahmensegmente (1) aus einem länglichen Streifen hergestellt werden, der eine Vielzahl von Segmenten (1) enthält, dessen Segmente (1) und Leiter (4) mit einander gegenüberliegenden durchgehenden Riegeln (2, 3) verbunden sind, wobei der Zwischenraum zwischen den Leitern (4) bei einen der Riegel (3) breiter als bei dem anderen Riegel (2) ist.

3. Verfahren nach Anspruch 1 oder 2, dadurch gekennzeichnet, daß die Leiter (4) zwischen hochstehenden Vorsprüngen (14, 29) auf dem Träger befestigt sind.

**Revendications**

1. Procédé de fabrication d'une puce à circuit intégré montée dans un boitier caractérisé en ce qu'il comprend les étapes suivantes:

préparer une pluralité d'éléments formant support de conducteurs (1) présentant chacun une pluralité de conducteurs (4), dont les extrémités sont respectivement connectées à des rails opposés (2, 3);

fixer les éléments formant support de conducteurs (1) à un support isolant (11), chaque conducteur (4) étant individuellement fixé au support (11);

ôter les rails (2, 3), les éléments (1) étant fixés séquentiellement, les rails (2, 3) étant ôtés après fixation à chacun de ceux-ci, mais avant fixation de l'élément suivant (1);

déposer une puce à circuit intégré sur le support (11); et réaliser les connections électriques entre la puce et les conducteurs (4); et

déposer un couvercle (23) sur le support (11), la puce et les éléments formant support de conducteurs (1) étant enfermés entre le support (11) et le couvercle (23).

2. Procédé selon la revendication 1 caractérisé en ce que les éléments formant support de conducteurs (1) sont obtenus à partir d'une bande longitudinale contenant une pluralité d'éléments (1), les éléments (1) et les conducteurs (4) associés étant connectés à des rails continus opposés (2, 3), l'espace entre les conducteurs (4) étant plus grand à l'un des rails (3) qu'à l'autre rail (2).

3. Procédé selon la revendication 1 ou 2 caractérisé en ce que les conducteurs (4) sont fixés entre des projections surélevées (14, 29) sur le support (11).

FIG.1

FIG.2

EP 0 163 077 B1

EP 0 163 077 B1

FIG.8

FIG.3

2

FIG.4

FIG.5

EP 0 163 077 B1

32

27

28

26

24

25

27

28

23

**FIG. 6**

27    28

23    24    25    26

**FIG. 7**

4